# EUROPEAN PATENT APPLICATION

(11) **EP 4 668 053 A1**
(43) Date of publication of application: **24.12.2025**
(21) Application number: 25180478.7
(22) Date of filing: 03.06.2025
(51) Int. Cl.: G06F 1/20, G06F 1/28, G06N 20/00

(54) **SMART FAN CONTROL FOR DATA CENTER POWERTRAIN EQUIPMENT**

(30) Priority: 18.06.2024 US 202463661124 P; 23.05.2025 US 202519217041
(71) Applicant: Vertiv Corporation, Westerville, OH 43082 (US)
(72) Inventor: PECORARI, Stefano, Westerville, 43082 (US); HEBER, Brian, Westerville, 43082 (US); GALUPPI, Graziano, Westerville, 43082 (US)
(74) Representative: Bryn-Jacobsen, Caelia

(57) **Abstract**

A power component includes at least one device processor configured to: obtain power output data, wherein the power output data comprises: a power characteristic associated with a high frequency component of a load; and a power characteristic associated with a low frequency component of the load. A power component may obtain a trained thermal management artificial intelligence (AI) and/or machine learning (ML) model. A power component may be based at least on the power output data and the trained thermal management AI and/or ML model, infer a cooling sub-system setting. A power component may set the cooling sub-system in accordance with the cooling sub-system setting.

## Description

### CROSS-REFERENCE TO RELATED APPLICATIONS

The present application claims the benefit under 35 U.S.C. § 119(e) of U.S. Provisional Patent Application Serial Number 63/661,124 filed June 18, 2024.

### TECHNICAL FIELD

The present disclosure relates to thermal control systems for electronic equipment, and more particularly to cooling systems for one or more components of a powertrain.

### BACKGROUND

Server farms often rely on one or more uninterruptible power supplies (UPS) to deliver power to each server. Many of these servers have variable loads, such as variable loads for servers used for data collection and training for artificial intelligence (Al)-based platforms. For example, during data collection cycles, the power required by Al platforms is relatively small, with processors operating often running under less than the rated power level (e.g., at 10% to 30% of maximum power). Once the data collection cycle is complete, a machine learning (ML) training process starts, with power used by processors reaching 100% of the rated power level and may even exceed the rated power level for short durations. The training process is then maintained for a period of time (e.g., 100 ms to 1 second) before the power drops back down to drops back down to lower power levels, such as the lower power levels of the data collection cycle. This high-frequency cycling period may last several minutes up to, and more than, several hours. Alternating between periods of high-power cycling are low-activity periods where the server processors operate consistently at low power.

Power is maintained through these load fluctuations in power usage by the power converters of the powertrain. During the high-power cycling period, excess heat is generated in these converters due to power switching by insulated gate bipolar transistors (IGBTs), metal-oxide-semiconductor field-effect transistors (MOSFETs), and other powertrain power semiconductor devices. Fans, or other cooling measures of a cooling sub-system, such as liquid cooling sub-systems are then turned on or increased in speed to mitigate the excessive heat. When servers are running in a low activity period, the servers do not require high power and therefore the UPS does not generate excessive heat that would necessitate increased cooling measures. While cooling measures can be controlled by preset thresholds that activate at predetermined temperatures, cooling systems that are activated by such thresholds cannot anticipate or predict the immediate increases in hardware temperature that can occur during a high-power cycling period, or the immediate decreases in temperature that can occur when the cooling system is activated and the processors has switched to a low activity period. Because of this inability to anticipate or predict temperature swings, the temperature of powertrain equipment components (e.g., power electronic switches, inductors, capacitors) during these power fluctuations varies greatly, negatively affecting the life of these components. Accordingly, it may be advantageous to have a thermal management system for equipment in a data center that is part of the powertrain, such as a UPS, a static transfer switch (STS), a power shelf, which can mitigate and decrease large swings in operating temperature when encountering variable loads.

### SUMMARY

Accordingly, the present disclosure is directed toward a power component, a system, and a method for controlling a temperature of a power component, such as during a variable load.

In one or more examples, a power component is disclosed. In one or more examples, the power component includes at least one device processor configured to: obtain power output data, wherein the power output data includes: a power characteristic associated with a high frequency component of a load, and a power characteristic associated with a low frequency component of the load; obtain a trained thermal management artificial intelligence (AI) and/or machine learning (ML) model; based at least on the power output data and the trained thermal management Al and/or ML model, infer a cooling sub-system setting; and set a cooling sub-system in accordance with the cooling sub-system setting.

In one or more examples, a power supply system is disclosed. In one or more examples, the power supply system includes a power component. The power component may include at least one device processor configured to: obtain power output data, wherein the power output data includes: at least one power characteristic level associated with a high frequency component of a load; and at least one power characteristic level associated with a low frequency component of the load; obtain a trained thermal management artificial intelligence (AI) and/or machine learning (ML) model; based at least on the power output data and the trained Al and/or ML model, infer a cooling sub-system setting; and setting a cooling sub-system in accordance with the cooling sub-system setting.

In one or more examples, a method for controlling a temperature of a power component is disclosed. In one of more examples, the method includes obtaining power output data, wherein the power output data includes: at least one power characteristic associated with a high frequency component of a load; and at least one power characteristic associated with a low frequency component of the load; obtaining a trained thermal management artificial intelligence (AI) and/or machine learning (ML) model; based at least on the power output data and the trained thermal management Al and/or ML model, inferring a cooling sub-system setting; and setting a cooling sub-system in accordance with the cooling sub-system setting.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF DRAWINGS

The numerous advantages of the disclosure may be better understood by those skilled in the art by reference to the accompanying figures.
FIG. 1A illustrates a block diagram of a power supply system for supplying power to a load, in accordance with one or more examples of the disclosure.
FIGS. 1B-1C illustrate block diagrams of a power component electrically coupled to a load, in accordance with one or more examples of the disclosure.
FIG. 2A illustrates a graph depicting a server load profile, in accordance with one of more examples of the disclosure.
FIG. 2B illustrates a graph depicting an extended server load profile for a traditional power system operating with a static cooling system, in accordance with one or more examples of the disclosure.
FIG. 2C illustrates a graph depicting a prophetic extended server load profile for a power component of the current disclosure that includes a dynamic cooling sub-system, in accordance with one or more examples of the disclosure.
FIG. 3 illustrates a process flow diagram depicting a method for controlling a temperature of a power component, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Disclosed is a power supply system, such as a power supply system for a data center, power components, and a method for controlling a cooling sub-system for a power supply system based on anticipated or predicted power loads, such as Al/ML loads. The power supply system may include one or more power components (e.g., switches and power units) as part of a powertrain. One or more power components may include at least one device processor configured to obtain power output data and obtain a trained thermal management artificial intelligence Al and/or machine learning (ML) model. The power component is also configured to infer a cooling sub-system setting based on the power output data and the thermal management Al/ML model and cause the cooling sub-system to operate at the cooling sub-system setting. The power output data includes power characteristics associated with high frequency components and low frequency components of a load. The high frequency component is a period of rapid switching (e.g., ~<1 sec) between low and high power that occurs when the server processors are collecting data (e.g., low power) and processing data (e.g., high power). The low frequency component includes long periods (e.g., ~>60 sec) of low power use. The device processor then utilizes the trained thermal management AI/ML model along with the power output data to predict when the server processor will require power for operating under specific high frequency components and low frequency components, and, based on that prediction, change a setting of the cooling sub-system of the power component and/or other components of the power supply system, such as a fan speed or a liquid circulation rate, in anticipation of changes in heat generation that will accompany the anticipated or predicted changes in power usage.

Examples of the present disclosure are particularly advantageous for thermal control of one or more components of the power supply system (e.g., including, but not limited to, a static transfer switch (STS), power distribution unit (PDU), power shelf, rack power distribution unit, and uninterrupted power supply (UPS) systems) that power electronic systems used for training server-based Al/ML models. These electronic systems have periods of high-power usage that increase temperatures, followed by periods of low power usage that reduce temperatures. Current UPS thermal control systems are often passive, waiting for a temperature threshold to be reached before changing a cooling sub-system setting. The time delay in waiting for a threshold to be reached results in large differences in temperature (dT) in high power and low power states, which can reduce component life. The thermal control system of the present disclosure predicts periods of high-power use and low power use and engages the cooling sub-system of the power system based on these predictions, reducing the latency period for adjusting to a change in power and/or temperature, and reducing the differences in temperature over time for power system componentry, increasing power system life.

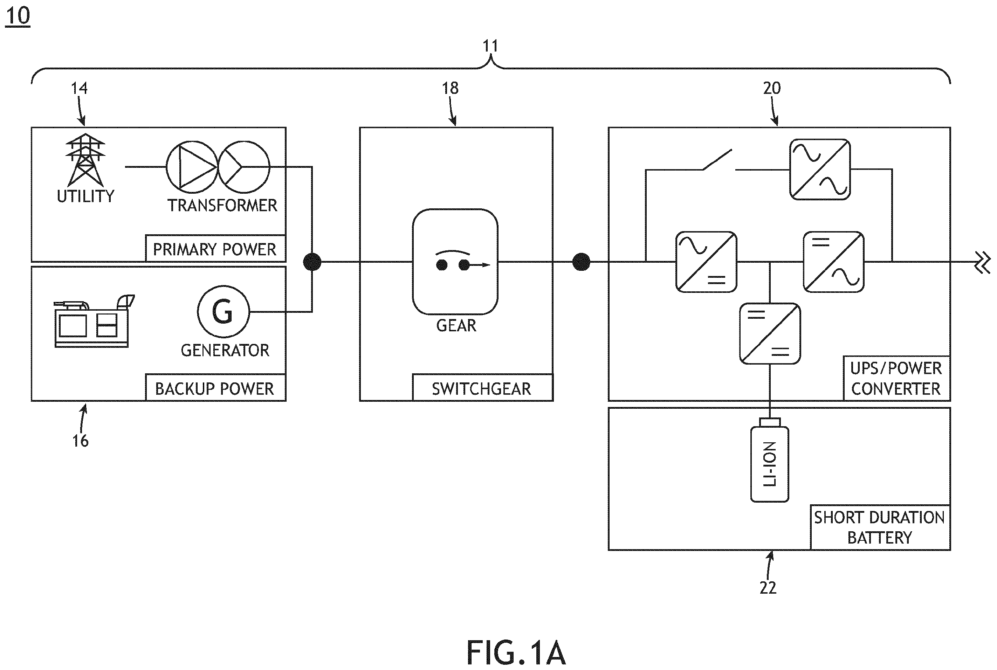

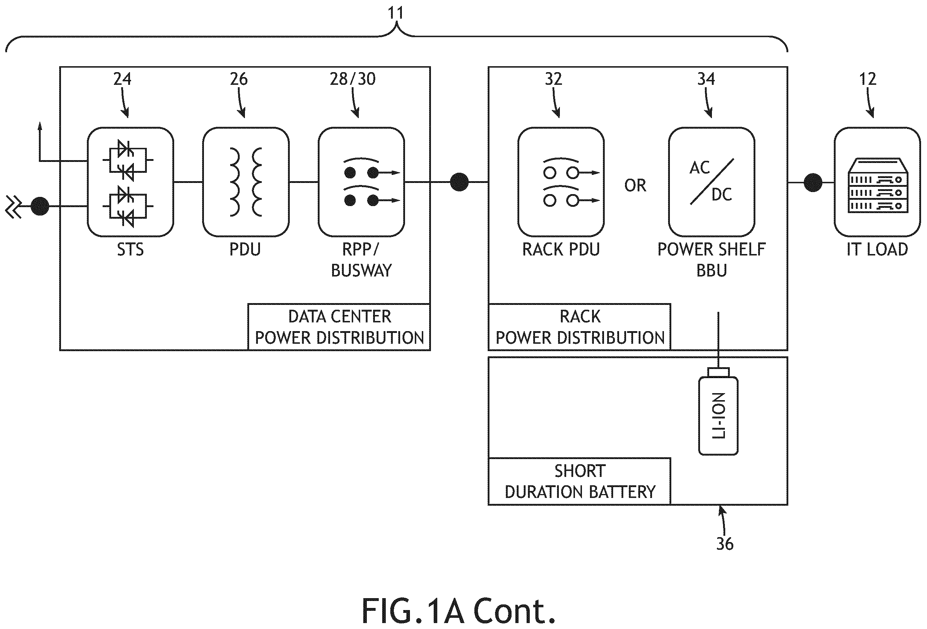

FIG. 1A illustrates a block diagram of a power supply system 10 (e.g., a powertrain) for supplying power to a load 12, in accordance with one or more examples of the disclosure. Power for the power supply system may originate from a utility power 14 or generator power 16. The power supply system 10 includes one or more power components 11. For example, the power supply system 10 may include one or more switchgears 18 that receive utility power 14 or generator power 16 and one or more UPSs 20 that receive power from the one or more switchgears 18 or other power sources. The UPS 20 may cause the power to be stored in a UPS battery 22, or send power through one or more components to support the load 12. These components include, but are not limited to, an STS 24, a PDU 26, a remote power panel 28, a busway 30, a rack PDU 32, a power shelf 34 and a backup battery unit 36.

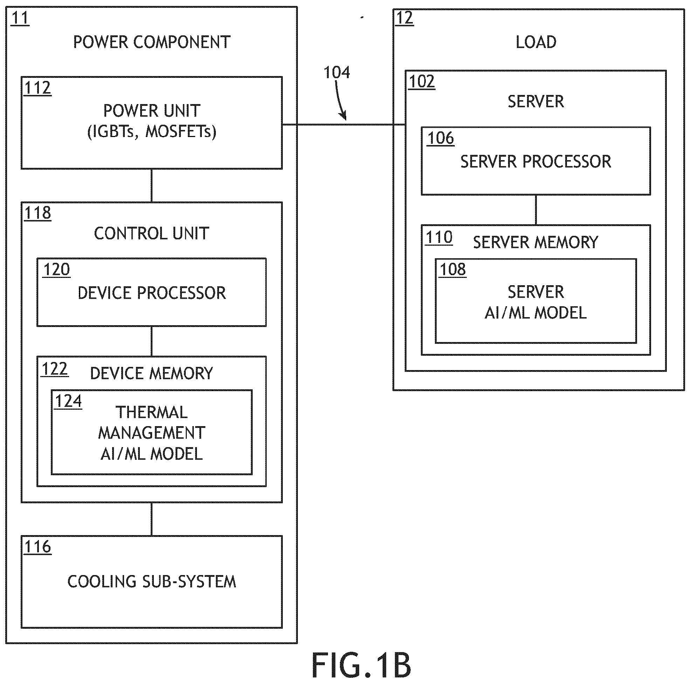

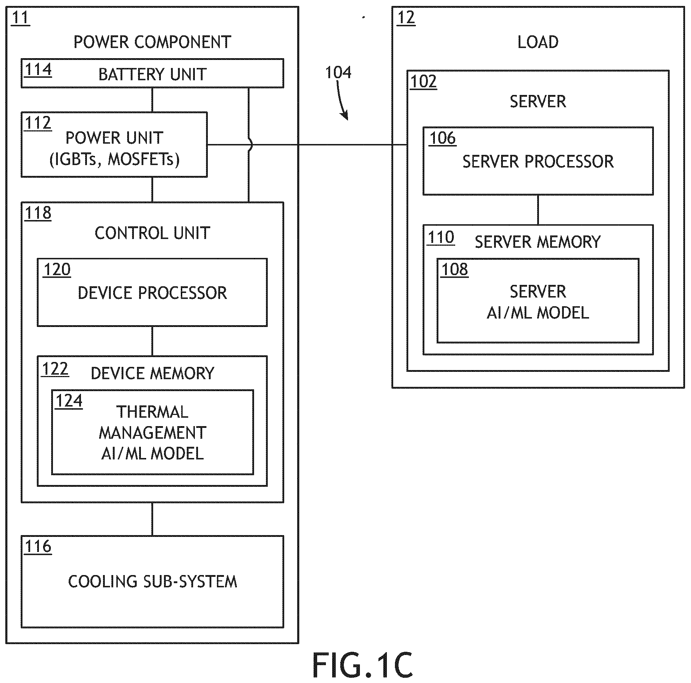

FIGS. 1B-1C illustrate block diagrams of a power component 11 electrically coupled to a load 12 (e.g., a server), in accordance with one or more examples of the disclosure. The power component 11 may include any device capable of delivering electrical power including, but not limited to, the UPS 20, the STS 24, the PDU 26, the remote power panel 28, rack PDU 32, and the power shelf 34. The power component 11 may be coupled to the load 12 (e.g., one or more servers 102) via a critical bus 104. The critical bus 104 facilitates the delivery of a critical load to the one or more servers 102. The one or more servers 102 use the critical load to power one or more server processors 106. The one or more server processors 106 may be used for any computing process and may require a variable load. For example, the one or more server processors 106 may be configured to obtain, build, and/or train a server AI/ML model 108 stored in a server memory 110, processes that often result in variable loads. While a generalized power component 11 is illustrated in FIG. 1B, a power component configured as a power supply (e.g., an uninterrupted power supply) as illustrated in FIG. 1C.

In examples, the power component 11 includes a power unit 112. The power unit 112 provides power conversion and/or distribution for the power component 11 as power is transferred to the load. The power unit 112 may include one or more power conversion devices including, but not limited to, rectifiers, and inverters. When in use, the power unit 112 may generate considerable amounts of heat via switching elements within the power unit 112, the switching elements including, but not limited to, insulated gate bipolar transistors (IGBTs) and metal-oxide-semiconductor field-effect transistors (MOSFETs).

In examples, the power component 11 may include a battery unit 114 for receiving power from the power unit 112 and transmitting power to the one or more servers 102, and a cooling sub-system 116 for controlling temperatures within the power component 11. The cooling sub-system 116 may include any type of cooling device including, but not limited to, air cooling devices and liquid cooling devices. For instance, the cooling sub-system 116 may include one or more fans. In another instance, the cooling sub-system 116 includes a pump and/or circulator for controlling the speed and/or flow rate of cooling fluid.

In examples, the power component 11 includes a control unit 118. The control unit 118 may be communicatively coupled to one or more of the battery unit 114, the power unit 112, and the cooling sub-system 116. The control unit is configured to perform one or more functions as described within this disclosure. The control unit 118 includes one or more device processors 120 and device memory 122. In examples, the one or more device processors 120 are configured to obtain, build, and/or train a thermal management Al/ML model 124 stored in the device memory 122. For example, the one or more device processors 120 may be configured to obtain power output data (e.g., data associated with power transmitted by the power component 11 to the one or more servers 102). In another example, the one or more device processors 120 may be configured to, based on the power output data and the trained thermal management Al/ML model, infer a cooling sub-system setting. In examples, the one or more device processors 120 are configured to set the cooling sub-system (e.g., adjust a fan speed) in accordance with the cooling sub-system setting.

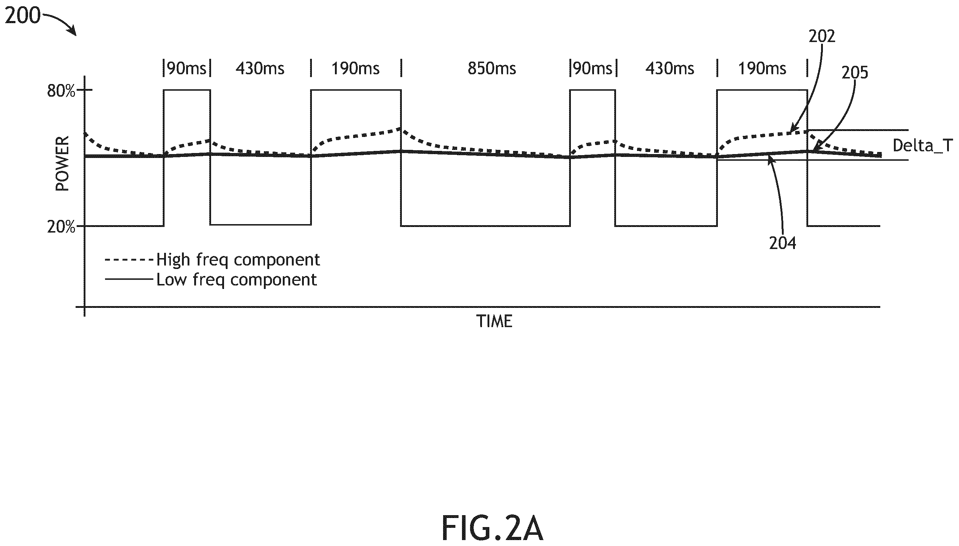

FIG. 2A illustrates a graph 200 illustrating a server load profile, in accordance with one of more examples of the disclosure. The graph 200 also illustrates a relative junction temperature (Tj) of an IGBT power switch disposed within the power unit 112 of a power component 11 (e.g., top line 202), and a relative temperature for a heatsink of one of the one or more IGBT power semiconductor devices (e.g., bottom line 204).

Server processors 106 that perform tasks requiring various loads, such as tasks associated with the server Al/ML model 108, have varied power characteristics based on the task performed. How the load is received affects the temperature of power components 11 (e.g., IGBTs and MOSFETs of the power unit 112). For example, when the one or more server processors 106 are collecting data, the power delivered to the one or more server processors 106 is relatively low, and low amounts of heat are generated by the one or more switches and related elements (e.g., IGBT power semiconductor device) of the power component 11 involved in delivering power to the one or more server processors 106. When the one or more server processors 106 have collected all required input data and begin training the server AI/ML model 108, the power delivered to the one or more server processors is relatively high, and high amounts of heat are generated by the one or more switches and related elements of the power components 11 involved in delivering power to the one or more server processors 106, increasing the temperature of the one or more server processors 106. This pulsing load received by the one or more server processors 106 (e.g., a high frequency component associated with the load) results in a correlating rise in temperature that is related to, or otherwise associated with, thermal impedance (RthJH) of the IGBT power semiconductor device and other elements of the power unit 112. The heatsink temperature (e.g., indicated by line 204) is affected to a lesser degree, resulting in a maximal temperature value 205 at the end of the last high-power pulse. This relatively small rise in temperature by the heatsink is related to, or otherwise associated with, ambient thermal resistance (RthHA) and thermal capacitance. Between the periods of pulsing loads are periods of low power non-pulsing loads.

The loads 12 that represent switching from a period of frequent pulsing (e.g., the high frequency component) to a period of low non-pulsing power loads are termed "low frequency components" (e.g., low frequency components associated with the load). Low frequency components include sets of high frequency components that can affect heatsink temperature in the power component 11 over time. Both high and low frequency temperature components sum up to determine power device junction temperature Tj and its oscillation during operation. High frequency components may be intrinsic to the physical construction of the power component 11, or elements of the power component 11 (e.g., IGBTs of the power unit 112) and may be resistant to change. However, thermal profiles of heat sinks and other power components 11 affected by the low frequency component may be adjusted through the use of cooling sub-system settings, such as fan speed or liquid circulation rates.

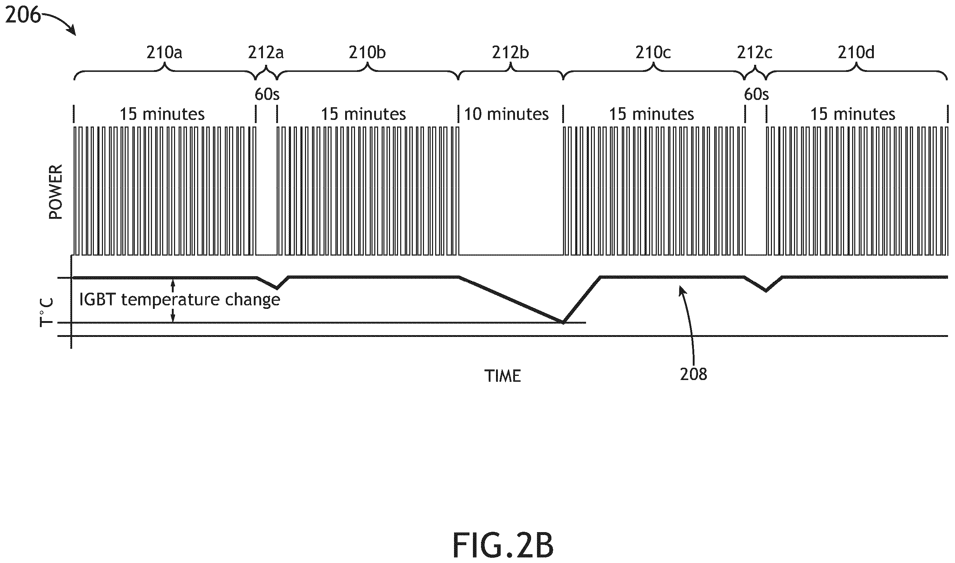

FIG. 2B illustrates a graph 206 illustrating an extended server load profile for a traditional power system operating with a static cooling system, in accordance with one or more examples of the disclosure. The graph 200 also illustrates a relative temperature for a heatsink of an IGBT power semiconductor device disposed within the power unit 112 of the power component 11 (e.g., line 208). The graph further illustrates frequent load shifting periods 210a-d and low use periods 212a-c. The frequent load shifting periods 210a-d feature a prominent high frequency component that may keep the temperature of the heatsink at a relatively elevated temperature even with the persistent cooling system operating. In contrast, the low use periods 212a-c feature a prominent low frequency component (low use period 212b) resulting in an initial sharp drop in heatsink temperature, followed by a sharp increase in heatsink temperature at the start of another frequent load shifting period (frequent load shifting period 210c). These large swings in temperature in the heatsink between the frequent load shifting periods 210a-d and the low use periods 212a-c can damage elements of the power component 11 over time, reducing the life of the power components 11.

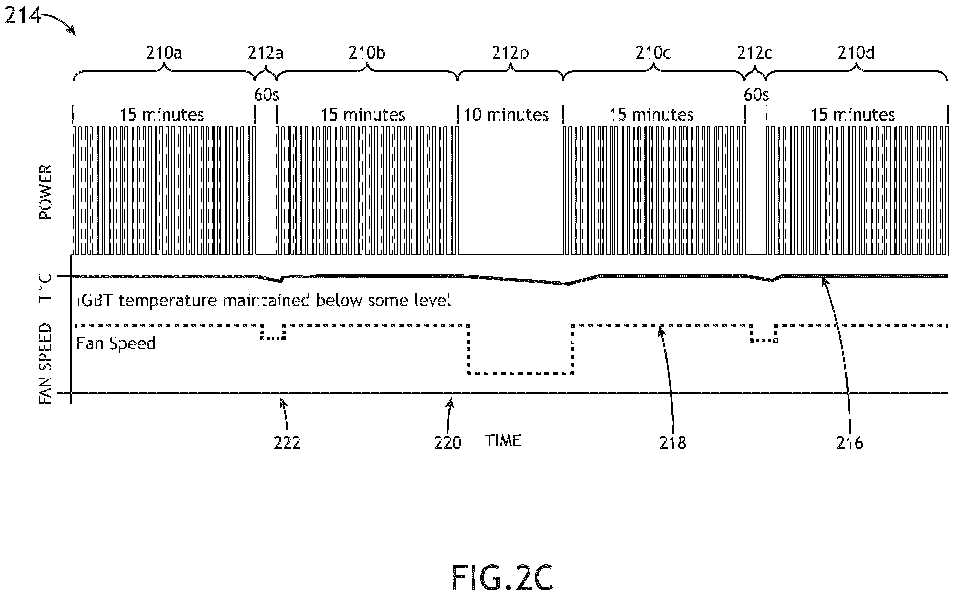

FIG. 2C illustrates a graph 214 illustrating a prophetic extended server load profile (e.g., with frequent load shifting periods 210a-d and low use periods 212a-c as graph 206 of FIG. 2B) for a power component 11 of the current disclosure that includes a dynamic cooling sub-system 116, in accordance with one or more examples of the disclosure. The graph 214 further illustrates a relative temperature for a heatsink of one of the IGBT power semiconductor devices (e.g., line 216) and a relative fan speed (e.g., line 218).

In examples, the cooling sub-system 116 is set (e.g., set to a cooling sub-system setting) based at least on power output data and a trained thermal management Al/ML model 124. For example, the one or more device processors 120 may change a fan speed within the cooling sub-system 116 based on an output inferred from the thermal management AI/ML model 124 that is based on power output data. The power output data may include any data or power characteristic related to or associated with power outputted by the power component 11 or a determination of load received by the one or more server processors 106 and may include, but not be limited to, a time-length of a load shifting period 210a-d and/or a low use period 212a-c, a mean power level of a load shifting period 210a-d and/or a low use period 212a-c, a frequency of occurrence of a load shifting period 210a-d and/or a low use period 212a-c, a start/end time of a load shifting period 210a-d and/or a low use period 212a-c, or an appearance of a sequence/pattern of load shifting periods 210a-d and/or low use periods 212a-c. For instance, the power output data may include one or more load characteristics from a high frequency component of the one or more server processors 106 (e.g., as determined by power delivered by the power component 11). In another instance, the power output data may include one or more load characteristics from a low frequency component (e.g., as determined by power delivered by the power component 11). The power output data may be received from one or more components of the power component 11. For example, one or more processors integrated with or in communication with the power unit 112 or battery unit 114 may detect a power characteristic and transmit associated power output data to the one or more device processors 120.

In examples, the one or more device processors 120 are configured to obtain a trained thermal management Al/ML model 124. For example, obtaining a trained thermal management AI/ML model 124 may include using supervised, unsupervised, or reinforced learning techniques. For instance, in the case of unsupervised learning, the thermal management Al/ML model 124 may autonomously explore and learn from labeled or unlabeled data to discover underlying patterns and structures. In another instance, the training may include incorporating feedback loops, enabling the thermal management Al/ML model 124 to iteratively refine its understanding and improve performance across a range of tasks. In another instance, training may include a dynamic adaptation mechanism that adjusts the balance between different learning modes (e.g., supervised, unsupervised and/or reinforced learning modes) based on the complexity and nature of the data, ensuring learning efficiency and adaptability to varying environments. In particular, the one or more device processors 120 may be configured to receive data relating to power cycles, thermal cycles, and/or heatsink temperatures, train the thermal management AI/ML model 124 based on the data, then, utilizing the trained thermal management AI/ML model 124 cause the cooling sub-system 116 to anticipate high frequency and low frequency components of the load 12, resulting in lower heatsink temperature swing and/or lower average heatsink temperature. Lower heatsink temperatures and lower average heatsink temperatures are possible because in certain types of loads, such as Al loads, the average dissipated power is lower than maximum load power.

In examples, training the thermal management AI/ML model 124 may include using supervised learning models including, but not limited to, linear regression, logistic regression, decision trees, random forests, support vector machines (SVM), k-nearest neighbors (k-NN), gradient boosting machines (GBM), and neural networks. In examples, training the thermal management AI/ML model 124 may include using unsupervised learning models including, but not limited to, k-means clustering, hierarchical clustering, Gaussian mixture models (GMM), principal component analysis (PCA), and t-distributed stochastic neighbor embedding (t-SNE). In examples, training the thermal management Al/ML model 124 may include using reinforcement learning models including, but not limited to, Q-learning, deep Q-networks (DQN), and policy gradient methods. Training the thermal management AI/ML model 124 may further utilize generative models such as variational autoencoders (VAE), generative adversarial networks (GAN), and Boltzmann machines.

In examples, the one or more device processors 106 are configured to, based on at least the power output data and the trained thermal management AI/ML model 124, infer a cooling sub-system setting. For example, and referring to FIG. 2C, if the thermal management Al/ML model 124 predicts that a low use period 212a is going to be relatively short in length (e.g., based on data power output data associated with high frequency components and low frequency components), the thermal management AI/ML model 124 may infer that the fan speed should be reduced by a relatively small amount (e.g., at time 220). In another example, if the thermal management AI/ML model 124 predicts that a low use period 212a is going to be relatively long in length (e.g., based on data power output data associated with high frequency components and low frequency components), the thermal management AI/ML model 124 may infer that the fan speed should be considerably reduced (e.g., at time 222). By decreasing fan speed, the heatsink temperature (e.g., line 216) fluctuates considerably less than the heatsink temperature in a non-predictive system, as shown in FIG. 2B. By predicting the length of low use periods 212 and adjusting the fan speed accordingly, the thermal management Al/ML model 124 may reduce overall temperature fluctuations of the heatsink and other power system components, increasing component life.

The one or more device processors 120 of the control unit 118 may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more device processors 120 may include any device configured to execute algorithms and/or instructions (e.g., program instructions stored in memory). In some examples, the one or more device processors 120 may be embodied as a desktop computer, mainframe computer system, workstation, image computer, parallel processor, networked computer, or any other computer system configured to execute program instructions. Further, the steps described throughout the present disclosure may be carried out by a single controller or, alternatively, multiple controllers. Additionally, the control unit 118 may include one or more controllers housed in a common housing or within multiple housings.

The device memory 122 may include any storage medium known in the art suitable for storing program instructions executable by the associated one or more device processors 120. For example, the device memory 122 may include a non-transitory memory medium. By way of another example, the device memory 122 may include, but is not limited to, a read-only memory (ROM), a random-access memory (RAM), a magnetic or optical memory device (e.g., disk), a magnetic tape, a solid-state drive and the like. It is further noted that the device memory 122 may be housed in a common controller housing with the one or more device processors 120. In some examples, the device memory 122 may be located remotely with respect to the physical location of the one or more device processors 120 and the control unit 118. For instance, the one or more device processors 120 of the control unit 118 may access a remote memory (e.g., server), accessible through a network (e.g., internet or intranet).

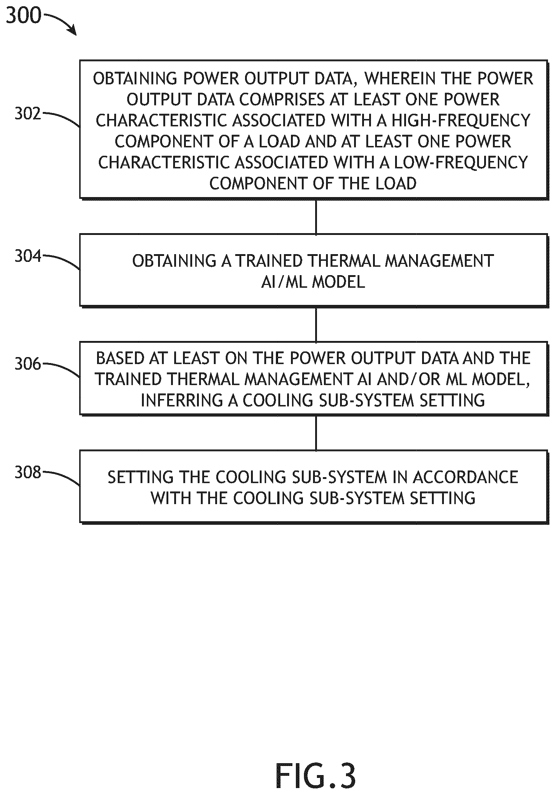

FIG. 3 illustrates a process flow diagram depicting a method 300 for controlling a temperature of a power component 11, in accordance with one or more examples of the disclosure. The method 300 may be used to control or set a cooling sub-system 116, as described herein. The method 300 enables the power component 11 to "thermally filter" the effect of server loads, such as Al loads, on key power component devices (e.g., IGBTs, capacitors, inductors, and MOSFETs) within the power component 11 potentially increasing component life. This method may also reduce a pump-out effect of power cycles and/or thermal cycles on thermal interface material (e.g., grease) used to couple power elements to the heatsink, mitigating the long-term increment of case-to-heatsink thermal resistance (RthCH), increasing reliability of the power component 11.

In examples, the method 300 includes a step 302 of obtaining power output data, wherein the power output data comprises at least one power characteristic with a high frequency component and at least one power characteristic associated with a low frequency component. For example, the method 300 may include a time-length of a load shifting period 210a-d and/or a low use period 212a-c.

In examples, the method includes a step 304 of obtaining a trained thermal management Al/ML model 124. Obtaining and/or training a trained thermal management Al/ML model 124 may include any AI/ML training models and methods as described herein. For example, obtaining and/or training a trained thermal management Al/ML model 124 may include deriving an algorithm (e.g., model) used to detect that the load is repeatedly changing from a load shifting period 210 to a low use period 212 over a given interval. In another example, the algorithm may learn, or otherwise be modified to determine, a predicted load shifting period 210 and/or low use period 212 that may occur in the future, In another example, the algorithm may learn, or otherwise be modified to determine, the high frequency average load power and the low frequency average load power and act to minimize both heatsink temperature swing and/or average temperature value. In another example, the algorithm may learn, or otherwise be modified to determine load levels that are used to set fan speeds (e.g., at high-speed levels or low speed levels).

In another example, the algorithm may learn, or otherwise be able to determine, when the load step from the low use period 212 to the load shifting period 210 is detected to determine if the predicted duration of the load shifting period 210 will be an extended period (e.g., lasting several minutes). For instance, if the duration of the load shifting period 210 is predicted to be several minutes, then the cooling sub-system setting (e.g., fan setting) will be set to an increased fan speed. In another instance, if the duration of the load shifting period 210 is predicted to be a short period (e.g., lasting less than several minutes), then the cooling sub-system setting (e.g., fan setting) may not be changed (e.g., held constant).

In another example, the algorithm may learn, or otherwise be able to determine, when the load step from the load shifting period 210 to the low use period 212 is detected, to determine if the predicted duration of the low use period 212 will be an extended period (e.g., lasting several minutes). For instance, if the duration of the low use period 212 is predicted to be several minutes, then the cooling sub-system setting (e.g., fan setting) will be set to a decreased fan speed. In another instance, if the duration of the low use period 212 is predicted to be a short period (e.g., lasting less than several minutes), then the cooling sub-system setting (e.g., fan setting) may not be changed (e.g., held constant).

In examples, the method 300 includes a step 306 of, based at least on the power output data and the trained thermal management Al and/or ML model, inferring a cooling sub-system setting, as described herein. In examples, the method 300 includes a step 308 of setting the cooling sub-system 116 in accordance with the cooling sub-system setting. For example, once the cooling sub-system setting is inferred by the one or more device processors 120 via the thermal management AL/ML model 124, the one or more device processors 120 may then send a signal to the cooling sub-system 116 setting the cooling sub-system 116 to a specific setting or value. For example, the signal may cause a fan in the cooling sub-system to be set to a specific speed.

In examples, the cooling sub-system setting may include a rate of change. For example, the cooling sub-system setting may include a fan speed change. For instance, the fan speed change may include a step function, a predetermined linear function of time, or may include a change based on a measured internal variable including, but not limited to, temperature and load current. In another example, the cooling sub-system setting may include a flow rate change, a flow speed change, and/or a liquid temperature change (e.g., for liquid cooling systems). For instance, the flow rate change may include a step function, a predetermined linear function of time, or may include a change based on a measured internal variable including, but not limited to, temperature and load current. In another example, the cooling sub-system setting may be implemented via an open loop control or a closed loop control. In another example, the thermal management Al/ML model 124 may include, or be adjusted by incorporating, an inverse model of a heatsink system, which may be used to optimize algorithm performance. For instance, because the relationship between dissipated power, change in heatsink temperature, and fan speed/flow rate may not be linear, the algorithm may further include a feedforward model that increases overall performance.

In examples, the power component 11 is configured to set a cooling sub-system of another power component 11 in accordance with the cooling sub-system setting, such as the cooling subsystem of another power component within the power supply system 10. For example, if a power component 11, such as an UPS infers a cooling sub-system setting based on power output data, the UPS may then set a cooling sub-system setting of another power component, an STS, within the power supply system 10. In this manner, any one of the power components 11 may then control a setting on another power component 11, lessening the need for multiple trained management Al/ML models.

In examples, a master controller is configured to set a cooling one or more power components 11 are configured to set a cooling sub-system 116. For example, the power supply system 10 may include a master controller that can obtain power output data, obtain a trained thermal management AI/ML model, infer a cooling sub-system setting, and then set a cooling sub-system for one or more power components (e.g., a UPS and an STS) of the power supply system 10.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Those skilled in the art will recognize that it is common within the art to describe devices and/or processes in the fashion set forth herein, and thereafter use engineering practices to integrate such described devices and/or processes into power and/or data processing systems. That is, at least a portion of the devices and/or processes described herein can be integrated into a data processing system via a reasonable amount of experimentation. Those having skill in the art will recognize that a typical power and/or data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical power and/or data processing system may be implemented utilizing any suitable commercially available components, such as those typically found in power and/or data computing/communication and/or network computing/communication systems.
Further examples are set out in the clauses below:
1. A power component comprising:
   at least one device processor configured to:
      obtain power output data, wherein the power output data comprises:
   a power characteristic associated with a high frequency component of a load; and
   a power characteristic associated with a low frequency component of the load;
   obtain a trained thermal management artificial intelligence (AI) and/or machine learning (ML) model;
   based at least on the power output data and the trained thermal management Al and/or ML model, infer a cooling sub-system setting; and
   set a cooling sub-system in accordance with the cooling sub-system setting.
2. The power component of clause 1, further comprising a power unit, wherein the power characteristic associated with the high frequency component of the load is associated with an element of the power unit.
3. The power component of clause 2, wherein the element of the power unit comprises an insulated gate bipolar transistor (IGBT).
4. The power component of clause 2, wherein the element of the power unit comprises a metal-oxide-semiconductor field-effect transistor (MOSFET).
5. The power component of any one of the preceding clauses, wherein the cooling sub-system comprises at least one fan, wherein the cooling sub-system setting comprises a fan setting.
6. The power component of any one of the preceding clauses, wherein the at least one device processor is further configured to infer a predicted low use period.
7. The power component of clause 6, whereupon inferring the predicted low use period, the cooling sub-system setting comprises decreasing a fan speed.
8. The power component of any one of the preceding clauses, wherein the at least one device processor is further configured to infer a predicted frequent load shifting period.
9. The power component of clause 6, whereupon inferring a predicted frequent load shifting period, the cooling sub-system setting comprises increasing a fan speed.
10. The power component of any one of the preceding clauses, wherein the power component comprises an uninterruptible power supply.
11. The power component of any one of the preceding clauses, further comprising the cooling sub-system.
12. The power component of any one of the preceding clauses, wherein the power component is included within a power supply system.
13. The power component of any one of the preceding clauses, wherein the power component is configured to set a cooling sub-system of another power component in accordance with the cooling sub-system setting.
14. A power supply system comprising:
   a power component comprising:
   at least one device processor configured to:
      obtain power output data, wherein the power output data comprises:
   at least one power characteristic level associated with a high frequency component of a load; and
   at least one power characteristic level associated with a low frequency component of the load;
   obtain a trained thermal management artificial intelligence (AI) and/or machine learning (ML) model;
   based at least on the power output data and the trained thermal management Al and/or ML model, infer a cooling sub-system setting; and
   setting a cooling sub-system in accordance with the cooling sub-system setting.
15. The power supply system of clause 14, further comprising a power unit, wherein the at least one power characteristic level associated with the high frequency component of a load is associated with an element of the power unit.
16. The power supply system of claim 15, wherein the element of the power unit comprises at least one of an insulated gate bipolar transistor (IGBT) or a metal-oxide-semiconductor field-effect transistor (MOSFET).
17. The power supply system of clause 16, further comprising the cooling sub-system, wherein the cooling sub-system comprises at least one fan, wherein the cooling sub-system setting comprises a fan setting.
18. The power supply system of clause 17, wherein the at least one device processor is further configured to infer a predicted frequent load shifting period, whereupon inferring the predicted frequent load shifting period, the cooling sub-system setting comprises increasing a fan speed.
19. The power supply system of any one of clauses 14-18, wherein the power component comprises an uninterruptible power supply.
20. A method for controlling a temperature of a power component comprising:
   obtaining power output data, wherein the power output data comprises:
   at least one power characteristic associated with a high frequency component of a load; and
   at least one power characteristic associated with a low frequency component of the load; obtaining a trained thermal management artificial intelligence (AI) and/or machine learning (ML) model;
   based at least on the power output data and the trained thermal management Al and/or ML model, inferring a cooling sub-system setting; and
   setting a cooling sub-system in accordance with the cooling sub-system setting.

It is further contemplated that each of the examples of the method described above may include any other step(s) of any other method(s) described herein. In addition, each of the examples of the method described above may be performed by any of the systems described herein.

It will be understood by those within the art that, in general, terms used herein, and especially in the appended claims (e.g., bodies of the appended claims) are generally intended as "open" terms (e.g., the term "including" should be interpreted as "including but not limited to," the term "having" should be interpreted as "having at least," the term "includes" should be interpreted as "includes but is not limited to," etc.).

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein.

## Claims

1. A power component comprising:
at least one device processor configured to:
obtain power output data, wherein the power output data comprises:
a power characteristic associated with a high frequency component of a load; and
a power characteristic associated with a low frequency component of the load;
obtain a trained thermal management artificial intelligence (AI) and/or machine learning (ML) model;
based at least on the power output data and the trained thermal management Al and/or ML model, infer a cooling sub-system setting; and
set a cooling sub-system in accordance with the cooling sub-system setting.

2. The power component of claim 1, further comprising a power unit, wherein the power characteristic associated with the high frequency component of the load is associated with an element of the power unit.

3. The power component of claim 2, wherein the element of the power unit comprises an insulated gate bipolar transistor (IGBT); or optionally
wherein the element of the power unit comprises a metal-oxide-semiconductor field-effect transistor (MOSFET).

4. The power component of any one of the preceding claims, wherein the cooling sub-system comprises at least one fan, wherein the cooling sub-system setting comprises a fan setting.

5. The power component of any one of the preceding claims, wherein the at least one device processor is further configured to infer a predicted low use period.

6. The power component of claim 5, whereupon inferring the predicted low use period, the cooling sub-system setting comprises decreasing a fan speed; or optionally whereupon inferring a predicted frequent load shifting period, the cooling sub-system setting comprises increasing a fan speed.

7. The power component of any one of the preceding claims, wherein the at least one device processor is further configured to infer a predicted frequent load shifting period.

8. The power component of any one of the preceding claims, wherein the power component comprises an uninterruptible power supply; and optionally
further comprising the cooling sub-system; and optionally
wherein the power component is included within a power supply system; and optionally
wherein the power component is configured to set a cooling sub-system of another power component in accordance with the cooling sub-system setting.

9. A power supply system comprising the power component as claimed in claim 1.

10. The power supply system of claim 9, further comprising a power unit, wherein the at least one power characteristic level associated with the high frequency component of a load is associated with an element of the power unit.

11. The power supply system of claim 10, wherein the element of the power unit comprises at least one of an insulated gate bipolar transistor (IGBT) or a metal-oxide-semiconductor field-effect transistor (MOSFET).

12. The power supply system of claim 11, further comprising the cooling sub-system, wherein the cooling sub-system comprises at least one fan, wherein the cooling sub-system setting comprises a fan setting.

13. The power supply system of claim 12, wherein the at least one device processor is further configured to infer a predicted frequent load shifting period, whereupon inferring the predicted frequent load shifting period, the cooling sub-system setting comprises increasing a fan speed.

14. The power supply system of any one of claims 9-13, wherein the power component comprises an uninterruptible power supply.

15. A method for controlling a temperature of a power component comprising:
obtaining power output data, wherein the power output data comprises:
at least one power characteristic associated with a high frequency component of a load; and
at least one power characteristic associated with a low frequency component of the load;
obtaining a trained thermal management artificial intelligence (AI) and/or machine learning (ML) model;
based at least on the power output data and the trained thermal management Al and/or ML model, inferring a cooling sub-system setting; and
setting a cooling sub-system in accordance with the cooling sub-system setting.
